# EUROPEAN PATENT APPLICATION

(11) **EP 1 065 611 A2**
(43) Date of publication of application: **03.01.2001**
(21) Application number: 99204577.3
(22) Date of filing: 03.10.1996
(51) Int. Cl.: G06F 17/50

(54) **A design environment for hardware/software co-design**

(30) Priority: 23.10.1995 US 6012 P; 26.01.1996 US 592697; 17.06.1996 US 19867
(62) Divisional of application: 96870126.8
(71) Applicant: INTERUNIVERSITAIR MICROELEKTRONICA CENTRUM VZW, 3030 Leuven-Heverlee (BE)
(72) Inventor: Van Rompaey, 2220 Heist-op-den-Berg (BE); Verkest, Diederik, 2950 Kapellen (BE); Vanhoof, Jan, 3018 Wijgmaal (BE); Lin, Bill, 3000 Leuven (BE); Bolsens, Ivo, 2900 Schoten (BE); De Man, Hugo, 3010 Leuven (BE)
(74) Representative: Van Malderen, Joelle

(57) **Abstract**

The present invention is related to a design apparatus compiled on a computer environment for generating from a heterogeneous specification a heterogeneous implementation of a system, said system comprising at least one digital system part, said heterogeneous specification comprising a number of paradigms having associated behavioural and structural languages, said heterogeneous implementation comprising hardware parts and software parts, said apparatus comprising:
- a database compiled on said computer environment, adapted for access by executable programs on said computer environment for generating the implementation of said system, said database comprising a plurality of objects representing aspects of said system wherein said objects comprise primitive objects representing the specification of said system and hierarchical objects being created by said executable programs while generating the implementation of said system, said hierarchical objects being refinements of said primitive objects and having more detail and preserving any one or all of said aspects to thereby generate said implementation of said system; and said database further comprising relations in-between said primitive objects and in-between said hierarchical objects and between said primitive objects and said hierarchical objects; and further comprising functions for manipulating said objects and said relations;
- means for simulating said system comprising a plurality of simulators for said behavioural and structural languages;
- means for implementing said system comprising a plurality of compilers for said behavioural and structural languages; means for allocating hardware components for an implementation of said system;
- means for assigning hardware subsystems and software subsystems to allocated hardware components;
- means for implementing the communication between said software subsystems and said hardware subsystems, one of the aspects of said communication being represented by ports; characterized in that said apparatus further comprises:
- means for creating processor models of said allocated hardware components as primitive objects in said database, said models comprising software models representing the software views on said hardware components and hardware models representing the hardware views on said hardware components,
- means for specifying said system in said apparatus, the specification in said apparatus comprising processes being primitive objects and comprising ports, said ports structuring the communication between said processes and being primitive objects, said process comprising a description of each of the different parts of said system in a specific host language encapsulation, said encapsulation comprising threads and context, a plurality of behavioural and structural languages being supported in said apparatus, and
means for encapsulating said simulators, said compilers, said hardware components, said hardware subsystems and said software subsystems in said apparatus to thereby create a consistent communication between said encapsulation and said encapsulated simulators, compilers, hardware components, hardware subsystems and software subsystems, thereby enabling the refinement process of said primitive objects while generating the implementation of said system.

## Description

### Field of the invention

The present invention relates to a design environment for hardware/software co-design. More specifically the hardware/software co-design of this invention comprises the specification, synthesis, and simulation of heterogeneous systems.

### Background of the invention

Digital communication techniques form the basis of the rapid breakthrough of modern consumer electronics, wireless and wired voice- and data networking products, broadband networks and multi-media applications. Such products are based on digital communication systems, which are made possible by the combination of VLSI technology and Digital Signal Processing.

Digital systems perform real-time transformations on time discrete digitized samples of analogue quantities with finite bandwidth and signal to noise ratio. These transformations can be specified in programming languages and executed on a programmable processor or directly on application specific hardware. The choice is determined by trade-offs between cost, performance, power and flexibility.

Hence digital systems are a candidate par excellence for hardware-software co-design.

In contrast to analogue processing, digital processing guarantees perfect reproducibility, storage and testability. Signal quality is a matter of exact mathematical operations. The price paid is the cost of hardware and the performance needed to satisfy the hard real-time character. This problem is now solved by the abundance of digital VLSI (Very Large Scale Integration) technology which provides for cheap storage and high speed computation. Therefore, the combination of VLSI technology and digital processing has made possible the breakthrough of modern consumer electronics, portable and personal communication, broadband networks, multi-media, and automotive applications.

The design process of the products for these applications is subject to a number of constraints. A first constraint is that they must be implemented in silicon or another hardware platform for power, performance and cost reasons. A second constraint is that these products implement systems conceived by a highly specialized system team thinking in terms of executable concurrent programming paradigms which, today, are not well understood by hardware designers. Hence most specifications are first translated into English and then redesigned in a specific hardware description language such as VHDL or VERILOG for the hardware components and a software description language such as C or assembler for the software components. Although the hardware and software have tight interaction, both hardware and software are designed separately. Only after system assembly, the software and hardware are run together. As a consequence, the design can be far from optimal or even erroneous, making a redesign cycle mandatory. This gap between system design and implementation is rapidly becoming the most important bottleneck in the design process of said products or said systems. Another constraint is that for reasons of cost-effectiveness and time-to-market, there is a need to increase design productivity by at least an order of magnitude. Yet another constraint is that re-use of designs as well as a design for re-use methodology will have to be adopted. Said methodology implies hardware/software co-design at several levels of implementation.

J. Buck et al. in "PTOLEMY: A framework for simulating and prototyping heterogeneous systems" (International Journal on Computer Simulation, January 1994) focus on an environment for hardware/software co-simulation. The proposed methodology does only allow for hardware/software co-design of systems based on a Data-Flow algorithm. Furthermore hardware/software interface synthesis is not supported.

United States Patent No. 5,197,016 discloses a computer-aided system and method for designing an application specific integrated circuit whose intended function is implemented both by hardware subsystems and software subsystems. The proposed methodology only allows for a single processor design and is only valid for specifications based on a state transition diagram. The hardware/software co-design of systems based on a heterogeneous specification is not supported.

S. Narayan, F. Vahid, and D. Gajski. in "System specification with the SpecCharts language" (IEEE Design & Test of Computers, pages 6 - 13, December 1992) disclose a methodology that builds on VHDL. The methodology does not support the hardware/software co-design of systems based on a heterogeneous specification.

P. Chou, R. Ortega, and G. Borriello. in "Synthesis of the hardware/software interface in microcontroller-based systems" (Proceedings of the IEEE International Conference on Computer-Aided Design, ICCAD 92, pages 488 - 495, November 1992) show a method for hardware/software interface generation for microcontroller based systems. Said method assumes that the user determines the software interfacing such as the communication with drivers before the start of the system synthesis task.

The prior art references, *Ismail and Jerraya: "Synthesis Steps and Design Models for Codesign", published in Computer, February 1995* and *Valderrama et al: "A Unified Model for Co-Simulation and Co-Synthesis of Mixed Hardware/Software Systems", Proceedings of the European Design and Test Conference, Paris, March 1995*, describe an environment for hardware-software co-design. A unified co-synthesis and co-simulation methodology is described therein. The environment also allows to accommodate several architectural models through the use of a library of communication models enabling the abstraction of existing communication schemes. The same module descriptions are usable with different architectures in terms of their underlying communication protocols.

A first problem with the SOLAR/COSMOS design environment as referred to in the documents is that it does not support the combination of different specification and description languages. It provides a unified model (SOLAR) in which several specification languages can be translated. The selection of the unified model (SOLAR) implies restrictions on the specification languages that can be used as input for co-design and co-synthesis of a heterogeneous system. Only those specification languages, the model of which corresponds to the SOLAR model (an extended Finite State Machine Model) can be supported by the design environment as described in the prior art references. At this moment, only SDL is supported by SOLAR. The C and VHDL paradigm is partially incompatible with SOLAR and only limited specification descriptions can be supported in SOLAR.

The design environment as described in documents therefore does not allow a heterogeneous system specification (i.e. one that uses different languages or "paradigms" for different system components) as input to co-design and co-synthesis. In the design process from the SOLAR model, different code paradigms such as C and VHDL code can be generated.

A second problem in the design environment for hardware/software co-design as described in the prior art references is the fact that the SOLAR/COSMOS method can only deal with fixed hardware/software target architectures. It can deal with various types of hardware/software target architectures as long as these are known in advance of the design process is as follows. Any hardware/software target architecture that serves as a target for SOLAR/COSMOS has to be known in advance (blocks, interconnections, drivers,...).

In particular, the design methodology as implemented in the SOLAR/COSMOS environment makes use of a library of communication models. A corresponding library of communication units is also included.

In SOLAR/COSMOS, at a high level of abstraction, the communication between the different system components is modelled as a logical communication network providing a set of services. More specifically, the communication occurs via logical channel units (the communication models). The communication synthesis (design) problem is then formulated as:
1. Fixing the number of communication units (selected from a library) that will implement the functionality of the communication network.
2. Assigning logical channel units to allocated communication units.

As a consequence, a communication unit must be available in the library for each possible communication between the systems components of the final design implementation (i.e. for every combination of processors).

A communication unit, namely, is an object that can execute one or several procedures that may share some common resource(s) (see D2, p.181). The sharing of the common resource(s) is controlled by a communication controller. A communication unit may correspond to either an existing communication platform or to a subsystem resulting from an earlier design session (D2, p.181). In both cases, the hardware/software target architecture of the final design implementation is already in place, it just needs to be used. The communication units available are placed into a library of components and are not synthesised for each design session (p.181).

These communication units in fact are real I/O processors. They provide an amount of functionality that can be used to implement the communication required by the logical channel units assigned to them, but they are always instantiated (allocated) as a whole, leading to sub-optimality and no customised, flexible design solution can be generated.

Thus, the SOLAR/COSMOS can only support a number of pre-defined hardware/software target architectures. Which part of the hardware/software target architecture will actually be used during the communication in a specific application will be different from application to application. Most applications, however, will not use all of the I/O mechanisms available in such a pre-defined architecture, and therefore, sub-optimal design implementations will result.

Neither of the prior art solutions provides a design environment based on a data-model that allows to specify, simulate and implement or synthesize heterogeneous hardware/software implementations starting from a heterogeneous system specification. In the following paragraphs of this section an analysis is made of the characteristics of specifications of such heterogeneous systems.

### Problem Definition

In the strictest sense digital systems are algorithms mapping digital signals into digital signals in real-time. The real-time constraint is determined by the repetition period of the algorithm for consuming an input frame and producing a new output frame.

The periodicity of this constraint and the nature of the signals leads to the fact that the elementary algorithm is a data-flow function.

A Synchronous Data-Flow (SDF) algorithm can be modeled as an acyclic graph where nodes are operators and edges represent data-precedences. This graph is called a data-flow graph. An operator can execute when a predetermined, fixed number of data (tokens) are present at its input and then it produces one or more output data (tokens).

Conditional selection of two operations to a single output is allowed. Operators have no state but arrays resulting from one algorithm execution can be saved for reuse in future executions (delay operator). Many digital processing algorithms are of this type. They can be described very efficiently by so called applicative programming languages like SILAGE.

In contrast, dynamic data-flow (DDF) algorithms contain data-dependent token production and consumption. They allow for while and if-then-else constructs.

Computer-Aided Design (CAD) environments for digital systems such as DSP-Station of Mentor Graphics, PTOLEMY, GRAPE-II of COSSAP all allow for specification of SDF and DDF and use as much as possible static scheduling to provide simulation speeds that are up to two orders of magnitude faster than event driven simulators such as in use for VHDL. This justifies the use of these simulation paradigms for digital system specification and validation.

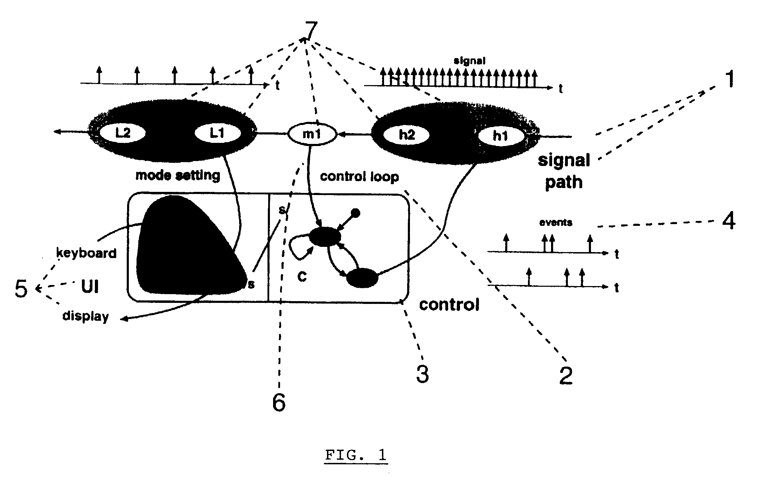

However, when we consider digital processing systems in the broad sense, a wider scope is necessary as illustrated in FIGURE 1 which is an abstraction of many practical implementations of digital processing systems. A careful look at FIGURE 1 allows us to identify five (in the sequel 1) 2) 3) 4) 5)) common characteristics of digital processing system specifications:
1. Digital systems typically comprise one (or more) signal paths 1 as well as slow control loops 2 and a reactive control system 3 taking events 4 of a slow environment such as a user interface (UI) 5 and slow status information 6 of the signal paths as inputs to control the mode or parameters of the signal paths.
2. A signal path 1 is usually a concatenation of data-flow functional (DFB) blocks 7, such as h1, h2,..., L2, often operating at fairly different data- and execution-rates and transforming the format of the data. The rate and format differences naturally result from operations such as: frequency down- or up-conversion, bit to symbol modulation, data-compression and error correction coding. When these DFBs operate on unfragmented signal words, they can best be specified as data-flow algorithms (e.g. in SILAGE, DFL, or C). Others that manipulate individual bits of the signals can be directly specified as Finite State Machines with Data paths (FSMD) at VHDL register transfer or behavioral level. Hence the specification format depends on the type of data-flow functional block.
3. DFBs in the signal path are internally strongly interconnected data-flow graphs with sparse external communication. Hence, from an implementation viewpoint, they are seldom partitioned over several hardware or software components. Rather they will be merged onto the same component if throughput and rate constraints allow to do so. Merging implies sequentializing the concurrent processes on a single component while still satisfying the timing constraints. This requires software synthesis : encapsulation techniques of single thread compilers in order to allow real-time scheduling of concurrent processes.
4. Control loops and mode control by parameter setting are common to almost all digital processing systems. For example, all digital communication systems have tracking and acquisition loops in order to synchronise frequency and phase of the receiver signal path to the characteristics of the incoming signal. Design of these loops is one of the most difficult tasks since their characteristics depend strongly on noise and distortion properties of the communication channel. It involves the design of phase-locked loops, delay-locked loops, and fast Fourier transforms, controlled by "events" disturbing the regularity of the signal streams. The occurrence rate of these events is orders of magnitude slower than the data-rate in the signal path. Hence, similar to the UI, the processes modeling these slow control loops and mode setting have no data-flow but reactive semantics. They run concurrently with the data-flow and often consist themselves of concurrent processes. Such a control dominated system can be described as a Program State Machine (PSM), which is a hierarchy of program-states, in which each program-state represents a distinct mode of computation. Formalisms such as StateCharts or SpecCharts, which include behavioral hierarchy, exception handling and inter-process communication modeling are needed to describe such systems. In practice, very often synchronization is specified in one or more concurrent C programs.
5. Digital systems contain both high and low data-rate blocks in the signal path. High data-rate blocks are synthesised directly in hardware. Low data-rate blocks are candidates for implementation on programmable processors. Hence digital systems are natural candidates for hardware/software co-design.

From the above it follows that digital systems require a combination of data-models for their specification. Specification languages are tightly coupled to these data-models, paradigms, simulators, and synthesis tools.

Nowadays, the dominant specification language of the digital system designer is C or a DFL for the main signal path whereas FSMDs and PSMs are usually described in a HDL. For the description of communication channels and communication protocols other formalisms such as timing diagrams, Extended Signal Transition Graphs, and Communicating Sequential Processes must be considered. A CAD system for digital systems must be able to encapsulate all these paradigms and there associated languages and design environments.

Digital systems design thus requires the ability to mix data-flow and reactive paradigms with widely different time constants. The difference in time constants between control- and data-flow poses special problems in simulation. It requires all processes to be simulatable at the highest possible abstraction level.

Not only the specification of a digital system is heterogeneous by nature. Also the implementation architecture of a digital system is heterogeneous. An example implementation architecture comprises the following types of components and the communication between these components:
- programmable processors,
- application specific processors with hardwired controller,
- application specific processors with specialized instruction set,
- hardware accelerators,
- micro controllers,
- communication blocks and memory,
- peripherals (DMA, UART,...).

Thus, a design method for a digital system must bridge the gap between the heterogeneous specification of the system and its heterogeneous implementation. Today's synthesis tools and compilers allow us to synthesize or program all the processor-accelerator-memory components once the global system architecture has been defined. However, the availability of these component compilers is necessary, but not sufficient. What is needed are the models and tools to refine the functional specification of a system into the detailed architecture: the definition and allocation of the components and their communication and synchronization. The most essential step is to generate the necessary software and hardware to make processors, accelerators, and the environment communicate.

One of the keys to mastering the complexity of digital system design is the reuse of components. The design process for a digital system must allow the modeling of reusable components and support a design for reuse methodology which allows to design components that are easily reusable. The problem in reusing previously designed components lies in the fixed communication protocols they use, which necessitates protocol conversions when processors with different protocols have to be interfaced. Nowadays, the selection of a protocol is done while designing the component: functional and communication behavior are intrinsically mixed. However, a good selection of the protocol is possible only when all components involved in the communication are known. Therefore, a design environment for digital systems has to allow that a component is initially described purely functional. Later, when the component is (re)used in a system, the design environment must allow to plug in the most appropriate communication behavior. This approach is in contrast with current hardware (VHDL) design practices, where communication and functional behavior are mixed.

Another key to mastering the complexity of digital system design is by means of modularity. In modular designs, the complete system functionality is split into communicating components of manageable complexity. The advantage of this approach is that the components can be reused and that the system is easier to adapt and maintain.

The disadvantage is the overhead because of the inter-component communication or because the compiler does not optimize over the component boundaries. Therefore, the inter-component communication semantics should be such that modularity can be removed easily when merging two components into a single component.

In the past, a lot of effort has been put in design environments that allow to implement the components of a digital system.

Languages with associated simulators, tuned towards specific application domains, allow to specify and simulate components at a high abstraction level. Hardware compilers can implement the component description into processors with highly specialized architectures. Software compilers allow to generate machine code for off-the-shelf programmable processors. Instruction set simulators allow to debug the machine code at different levels of abstraction (C, asm). Examples of such design environments are Cathedral-1/2/3, the ARM processor tool suite (C-compiler and the ARMulator), and the Synopsys synthesis tools. From the above it can be concluded that the components of digital systems can be implemented with off-the-shelf design environments. What is missing is the glue that links these design environments together and automatically interfaces the generated or off-the-shelf processors according to the system specification. Hence, a system design environment should allow to include existing design environments easily. It should provide synthesis tools for hardware/hardware and hardware/software interfacing that are processor and design environment independent. To achieve this, the specification method must allow to model off-the-shelf components on an as-is basis.

In summary, the following requirements can be defined for a hardware/software system design environment:
- Modularity being essential to master complexity, but the overhead should be minimal and removable.
- Different description languages are needed to allow each system component to be described with the most appropriate paradigm.
- The design environment must be able to model the heterogeneous conceptual specification, the resulting heterogeneous architecture and all refinement steps in between.
- Off-the-shelf components and the associated design environments need to be modeled.
- A clear separation between functional and communication behavior is required to allow to reuse designs.
- Processor independent interface synthesis is essential.

### Summary of the invention

A design environment meeting above-stated requirements for a hardware/software system co-design environment is disclosed in the present application. A hardware/software co-design environment based on a data-model that allows to specify, simulate, and synthesize heterogeneous hardware/software architectures from a heterogeneous specification is disclosed. Said environment is based on the principle of encapsulation of existing hardware and software compilers and allow for the interactive synthesis of hardware/software and hardware/hardware interfaces.

It is an object of the present invention to disclose a design environment for implementing a heterogeneous essentially digital system. Said system comprises a database compiled on a memory structure adapted for access by executable programs on a computer for generating the implementation of said heterogeneous essentially digital system, comprising a plurality of objects representing aspects of said digital system wherein said objects comprise primitive objects representing the specification of said digital system and hierarchical objects being created by said executable programs while generating the implementation of said digital system, said hierarchical objects being refinements of said primitive objects and having more detail and preserving any one or all of said aspects to thereby generate said implementation of said digital system; and further comprising relations inbetween said primitive objects and inbetween said hierarchical objects and between said primitive objects and said hierarchical objects; and further comprising functions for manipulating said objects and said relations. Said system further comprises means for specifying said heterogeneous digital system comprising a plurality of behavioral and structural languages; means for simulating said heterogeneous digital system comprising a plurality of simulators for said behavioral and structural languages; means for implementing said heterogeneous digital system comprising a plurality of compilers for said behavioral and structural languages; means for allocating hardware components for an implementation of said heterogeneous digital system; means for assigning hardware subsystems and software subsystems of said heterogeneous digital system to said hardware components; means for implementing the communication between said software subsystems and said hardware subsystems, one of the aspects of said communication being represented by ports; means for encapsulating said simulators, said compilers, said hardware components, said hardware subsystems and said software subsystems whereby creating a consistent communication between said encapsulated simulators, compilers, hardware components, hardware subsystems and software subsystems; and means for creating processor models of said hardware components as objects in said database, said models comprising software models representing the software views on said hardware components and hardware models representing the hardware views on said hardware components.

In an aspect of the present invention, the design environment further comprises means for creating I/O scenario models of said ports as objects in said database, said I/O scenario models representing the implementation of said ports on said hardware components, said implementation comprising software subsystems, hardware subsystems, and processor models with connections therebetween.

In another aspect of the present invention, the implementation of the communication between a first software subsystem and a first hardware subsystem in the design environment results in said first software subsystem with a first port being replaced by a second hardware subsystem with a second port, said first port and said second port representing an essentially identical communication.

Yet in another aspect of the present invention, further comprise means for selecting I/O scenario models for the ports of said first software subsystem; means for combining the software subsystems of said selected I/O scenarios; means for combining the hardware subsystems of said selected I/O scenarios.

In the design environment, a first I/O scenario model can represent the connection of said first port to said second port, said connection comprising a connection of said first port to said software subsystems of said I/O scenario model, connections of said software subsystems of said I/O scenario model to said software model, connections of said hardware model to said hardware subsystems of said I/O scenario model, and a connection of said hardware subsystems of said I/O scenario model to said second port.

In the design environment, the I/O scenario models can further comprise memory mapped I/O scenarios, instruction programmed I/O scenarios, and interrupt based I/O scenarios.

In an aspect of the present invention, said implementation is a simulation of said digital system. Said simulation can be a multi-abstraction level simulation, said multi-abstraction level simulation comprising substantially simultaneous low-level and high-level simulation.

Said simulation can be a multi-platform simulation being executed on a plurality of computers.

Said simulation can be a hybrid simulation comprising substantially simultaneous hardware implementations and computer simulations.

Said implementation can be a heterogeneous implementation comprising hardware subsystems and software subsystems, said software subsystems being executed on one or more of said hardware subsystems.

Said hardware subsystems can comprise any one or more of processor cores, off-the-shelf components, custom components, ASICs, processors, or boards.

Said software subsystems can comprise machine instructions for said hardware subsystems.

### Short description of the drawings

FIGURE 1 is a schematic representation of a heterogeneous digital system comprising various specification paradigms.
FIGURE 2 is a flowchart representing the method for hardware/software co-design of the present invention.
FIGURE 3 is an illustration of the primitive objects in the database and the relations in between said primitive objects.
FIGURE 4 is an illustration of the hierarchical objects in the database and the relations in between said hierarchical objects and between the primitive and hierarchical objects.
FIGURE 5 is an illustration of the process merge transformation.
FIGURE 6 is a flowchart of a specific embodiment of the implementation process for hardware/software co-design.
FIGURE 7 is a schematic representation of the functionality of the hardware/software interface generation.
FIGURE 8 is a schematic representation of a particular I/O scenario modeled in the database.
FIGURE 9 is a flowchart of a specific embodiment of the construction of a hardware/software co-simulation.
FIGURE 10 is a block diagram of a typical heterogeneous digital system: the pager application.
FIGURE 11 is a schematic representation of the pager application as described with the present invention.
FIGURE 12 is a block diagram of the pager after application of the process merge transformation.
FIGURE 13 is a block diagram of the pager after the communication channels have been tagged with a specific communication behavior.
FIGURE 14 is an illustration of the introduction of specific communication behavior in the pager application by refining a primitive channel into a hierarchical channel.
FIGURE 15 is an illustration of the implementation of a process in hardware, whereby the resulting hardware subsystems are encapsulated to make them communicate.
FIGURE 16 shows the details of the encapsulation of the hardware subsystems in this particular application.
FIGURE 17 is an illustration of the generation of a hardware/software interface between a software subsystem compiled on an ARM processor core and a hardware subsystem.

### Detailed description of the invention

In the sequel a design environment and a design methodology meeting the requirements of modularity, encapsulation of different description languages, modeling from a heterogeneous conceptual specification to a resulting heterogeneous architecture and all refinement steps inbetween, modeling capabilities for off-the-shelf components and the associated design environments, separation between functional and communication behavior and processor independent interface synthesis is disclosed. Said design environment in the sequel is called CoWare.

In the sequel it is to be understood that the concept refinement means converting or translating or transforming a specification of an electronic system into an implementation. Said implementation can be an architecture of components that has the same behavior as said specification or that executes said specification. Said implementation can also be an added development in the chain leading to a final implementation. Adding detail means that an implementation is made more specific or concrete as a result of an implementation decision on a previous level in the chain leading to a final implementation. To detail can also mean adding a material object such as a specific component or a specific communication inbetween components, as opposed to an abstract aspect on a previous level in the chain leading to a final implementation. Other instances of the concept refinement and of the concept detail are to be found in the sequel.

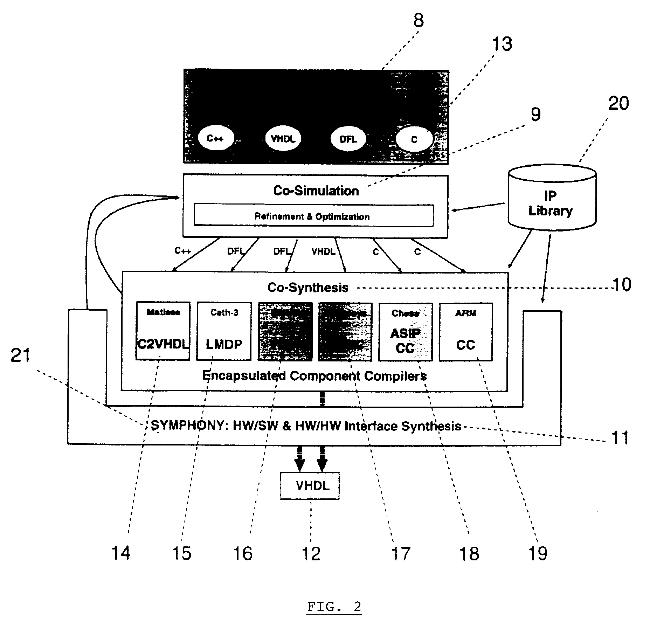

FIGURE 2 shows the architecture of the CoWare system.

The CoWare system supports four major design activities: co-specification 8, co-simulation 9, co-synthesis 10 and interface synthesis 11. The input is a heterogeneous specification of an electronic system, the output 12 is a netlist for prior-art commercial tools for the generation of the implementation layout. Said output preferably comprises structural VHDL or Verilog and machine code for the programmable processors.

The CoWare design environment is implemented on top of a data model in which modularity is provided by means of processes. Processes contain host language encapsulations which are used to describe the system components. Communication between processes takes place through a behavioral interface comprising ports. For two processes to be able to communicate, their ports must be connected with a channel. The inter-process communication semantics is based on the concept of the Remote Procedure Call (RPC). The data model is hierarchically structured and allows to refine channels, ports, and protocols into lower level objects, adding detail. We refer to the most abstract object as a primitive object. An object that contains more implementation detail, is referred to as a hierarchical object.

We first discuss the primitive objects. The hierarchical objects are used to refine the communication behavior of the system and are discussed afterwards.

A process is a container for a number of host language encapsulations of a component. A single process can have multiple host language encapsulations describing different implementations for the same component, or for the same component represented at different abstraction levels.

A host language encapsulation describes a component in a specific host language. Preferably C, C++, DFL, VHDL and Verilog are supported host languages. A CoWare language encapsulation is used to describe the system's structure. In a CoWare language encapsulation, one can instantiate processes and connect their ports with channels.

Other host language encapsulations comprise context and a number of threads. The context and thread contain code written in the host language of the encapsulation. The context contains code that is common to all threads in the encapsulation, i.e. variables/signals and functions as allowed by the semantics of the host language. As such the context provides for inter-thread (intra-process) communication.

Each primitive CoWare process (symbolized by an ellipse 13 in FIGURE 2) encapsulates concurrent program threads in a host language of choice. Concurrent threads communicate over shared memory inside a process. Inter-process communication is over uni-directional channels using a Remote Procedural Call (RPC) protocol. The reasons of this choice will be explained below.

Notice that in this way heterogeneous specification is supported: both hardware and software aspects, structural and behavioral aspects, and different specification paradigms (data-flow, control-flow,...) can be combined.

Co-specification allows to describe a functional specification based on the concept of communicating CoWare processes.

An important concept of CoWare is that basically no distinction is made between co-simulation and co-synthesis. Both are based on the concept of refining the specification for implementation, re-using existing compilers, emulators, and simulation processes.

In refinement for co-synthesis the designer performs an interactive coarse partitioning of the specifications over a user allocated architecture. This leads to a merger of component compiler consistent processes to be mapped on the same component. Component compiler consistent processes have an encapsulation in the same host language. Merging consists of in-lining the RPC calls between said processes and leads to two subproblems: the mapping of the concurrent threads in the processes on a processor re-using existing component compilers 14, 15, 16, 17, 18, 19 and the refinement of the communication between processes into hardware and software communication protocols that implements it. The implementation of concurrent threads and intra-process communication must be taken care of by using Real-Time Operating Systems (RTOS), micro-kernels or software synthesis in case of programmable processors or by providing a library based communication protocol shell around the existing hardware synthesis tools. Refinement of the inter-process communication means again a refinement of the primitive RPC communication by expanding the communication ports into implementable protocols available in a protocol library 20. It is also possible to assign channel processes to abstract channels.

In principle all of this is open to the user who can add his own library for communication protocols. On the other hand CoWare provides in the SYMPHONY toolbox 21 a methodology for interface synthesis whereby every communication channel is refined by selection of a communication scenario. In this way automated synthesis of hardware/hardware and hardware/software interfaces, including the generation of the software drivers in programmable processors is possible. This is an essential part of hardware/software co-design.

After the compilation of all components, all hardware is available as structural VHDL and all software for the processors is in C which can be compiled on the host compiler of the programmable components. The final step is to link all the synthesis and hardware descriptions to drive commercial back-end tools to generate layout.

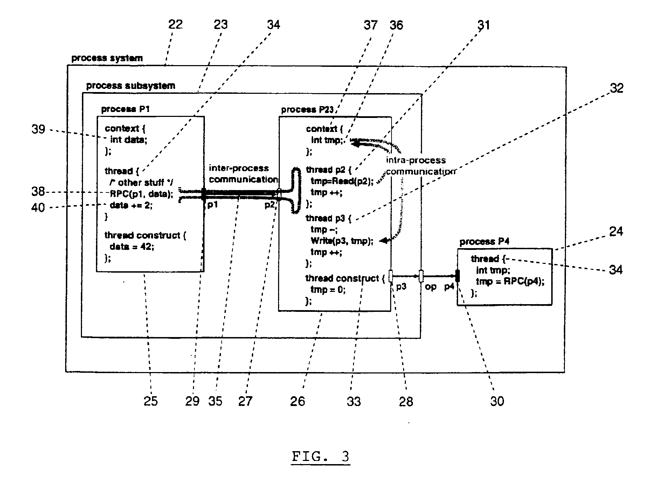

In FIGURE 3, the processes system 22 and subsystem 23 contain a CoWare language encapsulation. The CoWare language encapsulation of system 22 describes how it is built up from an instance of subsystem 23 and an instance of P4 (24). The processes P1 (25), P23 (26), and P4 (24) each contain a C language encapsulation.

Ports are objects through which processes communicate. A primitive port is characterized by a protocol and a data type parameter.

There is one implicit port, the construct port, to which an RPC is performed exactly once at system start-up.

In FIGURE 3 the process P23 (26) has two primitive ports p2 (27) and p3 (28), next to the implicit construct port.

Protocols define the communication semantics of a port. A primitive protocol is one of master, inmaster, outmaster, inoutmaster, slave, inslave, outslave, inoutslave. Each primitive protocol indicates another way of data transport. The in, out, and inout prefix indicates the direction of the data. The master, slave postfix indicates the direction of the control: whether the protocol activates an RPC (master) or services an RPC (slave). In the remainder of this text, ports with a slave/master protocol are usually referred to as slave/master ports.

In FIGURE 3 master ports (29, 30) are represented by the small shaded rectangles on a process' perimeter. Slave ports (27, 28) are represented by small open rectangles on the perimeter. The data direction of a port is represented by the arrow that connects to a port. In FIGURE 3 port p1 (29) is an outmaster port and port p2 (27) is an inslave port.

A protocol may further have an index set. The indices in the index set are used to convey extra information about the data that is transported. For example the primitive protocol used to model the memory port of a processor will have an index to model the address of the data that is put on the memory port.

A thread is a single flow of control within a process. A thread contains code in the host language of the encapsulation of which the thread is a part. The code in a thread is executed according to the semantics of the host language. We distinguish between slave threads and autonomous threads.

Slave threads are uniquely associated to slave ports and their code is executed when the slave port is activated (i.e. when an RPC is performed to the slave port). There is one special slave thread which is associated to the implicit construct port and can be used to initialize the process.

In FIGURE 3 the process P23 (26) contains two regular slave threads (31, 32) associated to the slave ports p2 (27) and p3 (28) respectively, next to the special construct slave thread (33).

Autonomous threads are not associated to any port and their code is executed, after system initialization, in an infinite loop.

In FIGURE 3 processes P1 (25) and P4 (24) each contain an autonomous thread (34).

A language encapsulation can contain multiple slave and autonomous threads that, in principle, all execute concurrently.

A channel is a point-to-point connection of a master port and a slave port. Two ports that are connected by a channel can exchange data. Channels can be uni- or bi-directional. A primitive channel provides for unbuffered communication. It has no behavior: it is a medium for data transport. In hardware it is implemented with wires. In software it is implemented with a (possibly in-lined) function call. In this way, primitive channels model the basic communication primitives found back in software and hardware description languages.

In the strict sense only point-to-point channels connecting one master to one slave port are allowed. However, a person skilled in the art, can easily remove this restriction to allow channels connecting two master ports or two slave ports, or to allow channels connecting multiple slave and master ports.

Such an extended description, can be transformed into the basic model, by using a default or user-defined translation scheme.

In FIGURE 3, there is a primitive channel (35) that connects port p1 (29) of process P1 (25) with port p2 (27) of process P23 (26).

Communication always happens between two threads. Communication between threads that are part of the same process is denoted as intra-process communication. Communication between threads in different processes is denoted as inter-process communication.

Intra-process (inter-thread) communication is done by making use of shared variables/signals that are declared in the context of the process. Avoiding that two threads access the same variable at the same time is host language dependent. It is the user's responsibility to protect critical sections using the mechanisms provided in the host language.

In FIGURE 3, intra-process communication occurs in process P23 (26).

The variable tmp (36) declared in the context (37) is shared by slave thread p2 (31) and slave thread p3 (32).

Inter-process (inter-thread) communication with a primitive protocol is RPC based. On a master port, the RPCfunction can be used to initiate a thread in a remote process. A master port can be accessed from anywhere in the host language encapsulation (context, autonomous threads, slave threads) with the exception of the construct thread.

The RPC function returns when the slave thread has completed, i.e. when all the statements in the slave thread's code are executed. In the slave thread (uniquely associated with a slave port), the Read and Write functions can be used to access the data of the slave port.

The Index function is used to access the indices of the protocol of the port. The RWbar function is used on an inoutslave port to determine the actual direction of the data transport. A slave port can only be accessed from within its associated slave thread.

A bi-directional port can be used to both send and receive data.

However, according to the strict RPC semantics this cannot be done by the same RPC call. In a single RPC call, one uses the bi-directional port either in the input or in the output direction but not in both directions. For a person skilled in the art, it is easy to extend the strict RPC semantics to full fledged function call semantics where arguments are passed to a remote procedure and results are received back.

In FIGURE 3, inter-process communication occurs between processes P1 (25) and P23 (26) over the channel (35). When the RPC statement (38)in the autonomous thread (34) is reached, the value of the local variable data (39) is put on the channel (35), and the control is transferred to the slave thread p2 (31). The autonomous thread (34) is halted, until the last statement of the slave thread (31) is executed. After that the autonomous thread (34) resumes by executing the statement (40) after the RPC statement (38).

By using primitive channels, ports, and protocols, the designer first concentrates on the functionality of the system while abstracting from terminals, signals, and handshakes. Once the designer is convinced that the processes of the system are functionally correct, the communication behavior of the system can be refined. Communication refinement in CoWare is carried out by making the objects involved in the communication (channels, ports, and protocols) hierarchical.

Hierarchical channels are processes that assign a given communication behavior to a primitive channel. The behavioral interface of a hierarchical channel is fixed by the ports connected by the primitive channel. Making a channel hierarchical, can drastically change the communication behavior of two connected processes. It can, for example, parallelize (pipeline) the processes by adding buffers. The one property that is preserved by making a channel hierarchical is the direction of the data transport.

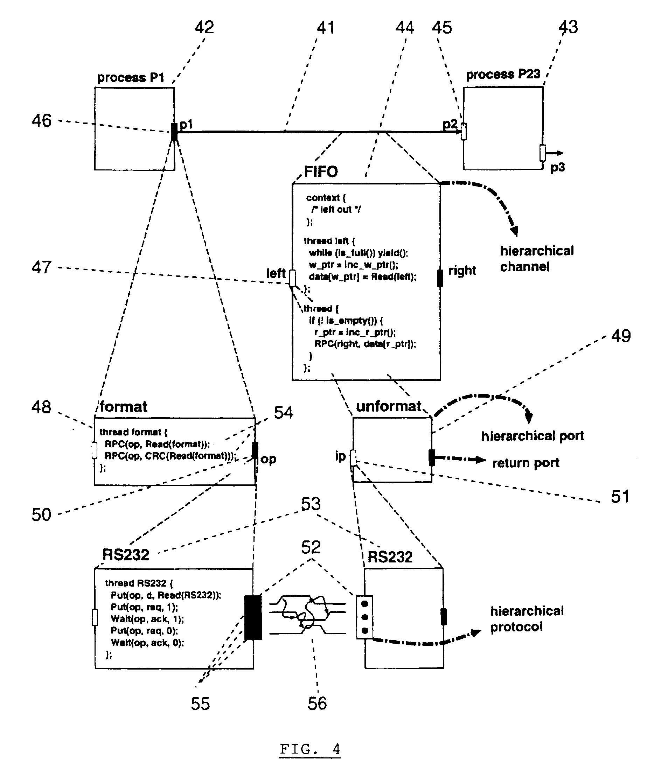

In FIGURE 4, the primitive channel (41) between processes P1 (42) and P23 (43) is refined into a hierarchical channel (44) with FIFO behavior. The FIFO hierarchical channel (44) decouples the autonomous thread of process P1 (42) and the slave thread associated with port p2 (45) of process P2 (43). The effect is that the rate at which process P1 (42) can issue RPCs is no longer determined by the rate at which process P23 (43) can service the RPCs. The FIFO hierarchical channel (44) takes care of the necessary buffering of data.

Hierarchical ports are processes that assign a given communication behavior to a primitive port. The behavioral interface of the hierarchical port is partially fixed by the primitive port it refines. The hierarchical port process should have one port, which we call the return port, that is compatible with the primitive port. Making a primitive port hierarchical, preserves the data direction (in/out). Two ports are compatible if their primitive protocols are compatible, if they have equal data type, and if they have equal protocol indices. The following primitive protocols are compatible : (master, slave); (inslave, outmaster); (inslave, inoutmaster); (outslave, inmaster); (outslave, inoutmaster); (inoutslave, inmaster); (inoutslave, outmaster); (inoutslave, inoutmaster). Two hierarchical protocols are compatible if their primitive protocols are compatible and they have the same name.

In FIGURE 4 we impose a certain data formatting for the data transported over the channel (41) between process P1 (42) and the FIFO hierarchical channel (44). This is achieved by making the primitive ports p1 (46) and left (47) hierarchical. The format process (48) that refines port p1 (46) might for example add a cyclic redundancy check to the data that is transported. The unformat process (49) that refines port left (47) of the FIFO hierarchical channel (44) then uses this cyclic redundancy check to determine whether the received data is valid. The actual data and the cyclic redundancy check are sent sequentially over the same primitive channel between ports op (50) and ip (51). As a consequence, the data rate between the format (48) and unformat (49) process is twice the one of process P1 (42).

Primitive protocols provide a classification of all hierarchical protocols. A primitive protocol determines the communication semantics, but not the communication implementation: it does not fix the timing diagram used in the communication. Hierarchical protocols refine primitive protocols with a timing diagram and the associated I/O terminals. Hierarchical protocols are high level models for alternative implementations of a primitive protocol: they preserve both data direction and control direction of the primitive protocol.

To access the terminals of the hierarchical protocol, a hierarchical port is introduced at the same time. The terminals can be accessed from within the thread code by using the functions Put, Sample, and Wait.

In FIGURE 4, the primitive protocol of the port (50) and ip port (51) of the format (48) and unformat (49) process are refined into an RS232 protocol (52). In the RS232 hierarchical port (53), an RPC (54) issued in the format process (48) on the op port (50) is converted into manipulations of the terminals (55) according to a timing diagram (56).

The CoWare model is implemented on a computer or on a plurality of computers and a set of application programmer's interface (API) functions is available.

When a CoWare system description is parsed, a representation of the system in memory is created in which the objects of the description are related to each other. All tools of the CoWare environment use these API functions to analyze, manipulate, and refine the system description.

Due to the selection of RPC as inter-process communication, the classification of protocols and the structuring of a process in encapsulations with context and threads, a process merge transformation can be implemented.

The goal of this transformation is to combine a number of process instances, that are described in the same host language, into a single host language encapsulation that can then be mapped by a host language compiler onto a single processor.

In the process of merging, all remote procedure calls are in-lined: each slave thread is in-lined in the code of the thread that calls it through an RPC statement. Because of the semantics of RPC communication, this transformation does not alter the behavior of the original system, provided that care is taken to avoid name clashes. The result of merging is a single host language encapsulation that contains a single context, a single construct thread, one or more autonomous threads, possibly multiple slave threads to service RPC requests from external process (not involved in the process merge transformation), possibly multiple RPCs to slave threads in external processes (not involved in the process merge transformation).

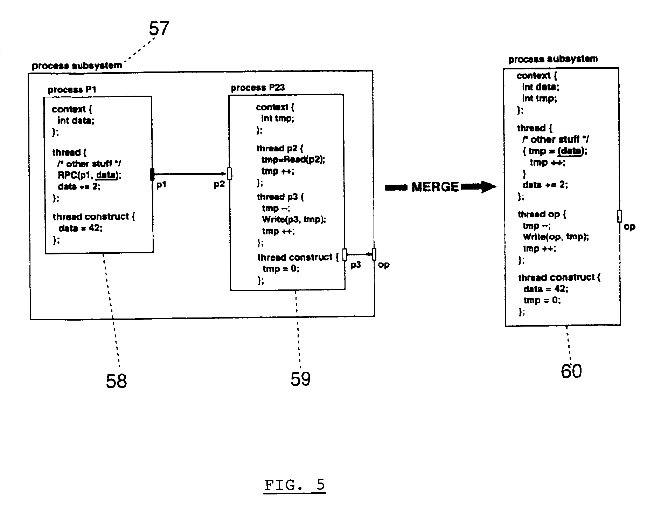

FIGURE 5 shows the effect of merging the process instances (25, 26) in the subsystem process (23) of FIGURE 3. The subsystem process (57) has a CoWare language encapsulation. After merging the instances (58, 59), we obtain a C language encapsulation (60) which is added to the subsystem process.

The benefit of merging processes is that the in-lining transformation eliminates the overhead that accompanies execution of (remote) procedure calls. It further reduces the number of concurrent threads and, therefore, the overhead that accompanies the switching between threads. Finally, it allows the host language compilers to optimize over the boundaries of the original processes.

The port and protocol hierarchy provides a clear separation between functional and communication behavior. Traditionally, the description of a component contains both functional and communication behavior in an interleaved way. When such a component has to be re-used, in an environment other than it was intended for, the designer has to change those parts of the description of the component that have to do with communication. In CoWare, a component's behavior is described by a process that makes use of RPC to communicate with the outside world. Such processes can be connected with each other without modifying their description (modularity). By using primitive ports and primitive protocols, the designer concentrates on the functionality of the system while abstracting from terminals, signals, and handshakes.

Later, when the component is instantiated in a system, the primitive protocol is refined into the best suited hierarchical protocol, taking into account the other system components involved. This fixes the timing diagram and terminals used to communicate over that port. The port containing the hierarchical protocol, is made hierarchical to add the required communication behavior that implements the timing diagram of the selected hierarchical protocol. Again this is achieved without modifying the description of any of the processes involved.

Because of this property it is feasible to construct libraries of functional building blocks and libraries of communication blocks that are re-usable: they can be plugged together without modifying their description. After blocks have been plugged together, any communication overhead (chains of remote procedure calls) can be removed by in-lining the slave threads that serve the RPCs. The result is a description of the component in which function and communication are interleaved seamlessly and which can be compiled into software or hardware as efficiently as a description in the traditional design process.

The above method reduces the amount of protocol conversions needed at the system level and allows to postpone the selection of the communication protocol and its implementation until late in the design process, in this way achieving the requirements of "design for re-use". The concept of hierarchical protocols is also useful to model off-the-shelf components ("re-use of designs"), because the timing diagrams according to which a processor communicates are abstracted in it.

The input to the implementation refinement process is a functional specification: a CoWare language encapsulation consisting of a number of process instances (i.e. host language encapsulations), exhibiting both intra-process and inter-process communication behavior. In a first step, allocation is performed. In this step the number and type of processors are selected that will serve as the target for implementing the input specification. After allocating the necessary processor resources, an assignment step is performed. In this step each process instance of the input specification is assigned to one of the allocated processors.

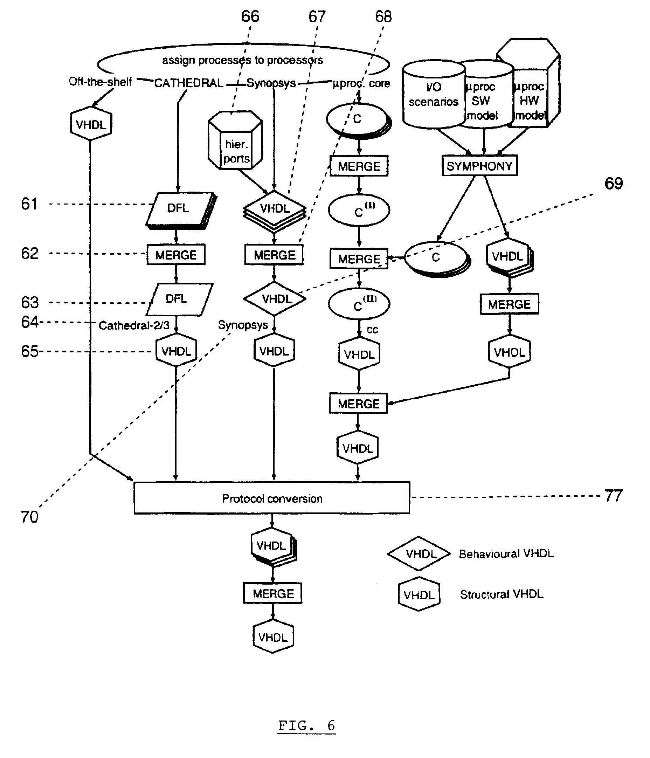

The rest of the implementation path is illustrated in FIGURE 6.

All process instances bound to a single processor are merged. This results in a system with a one-to-one mapping between (merged) processes and allocated processors. In FIGURE 6, all DFL processes (61) are merged (62) into a single DFL process (63).

The host language encapsulation from each (merged) process instance now has to be compiled onto its processor target using a host language compiler. This comprises the following steps:
(1) The CoWare concepts of autonomous thread, slave thread, and shared context are implemented on the processor target
(2) The inter-process communication is implemented.
(3) The resulting processors are encapsulated so that they can be connected with the rest of the system.

In step (1) existing (commercial) host language compilers are re-used. When such a host language compiler does not directly support the CoWare concepts of autonomous thread, slave thread, and shared context, the CoWare environment supports two alternatives:
- the host language compiler is extended with libraries that support such concepts (multi-thread library);
- software synthesis is performed to translate the host language encapsulation to a description that can be handled by the host language compiler.

In FIGURE 6, the DFL process (63) is compiled with the Cathedral compiler (64). The result is a VHDL net list (65) of the implementation.

In step (2) when the process is compiled on a non-programmable processor, the implementation of inter-process communication comprises the steps of refining the primitive ports/protocols into appropriate hierarchical ports/protocols and merging the hierarchical ports with the process.

In FIGURE 6, hierarchical ports (66) are added to the VHDL processes (67). After merging (68) all processes (67), the resulting VHDL process (69) is compiled with the Synopsys compiler (70).

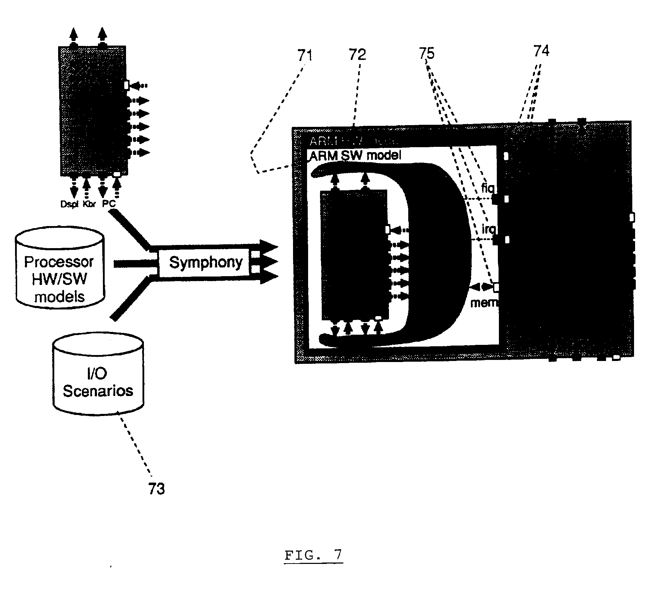

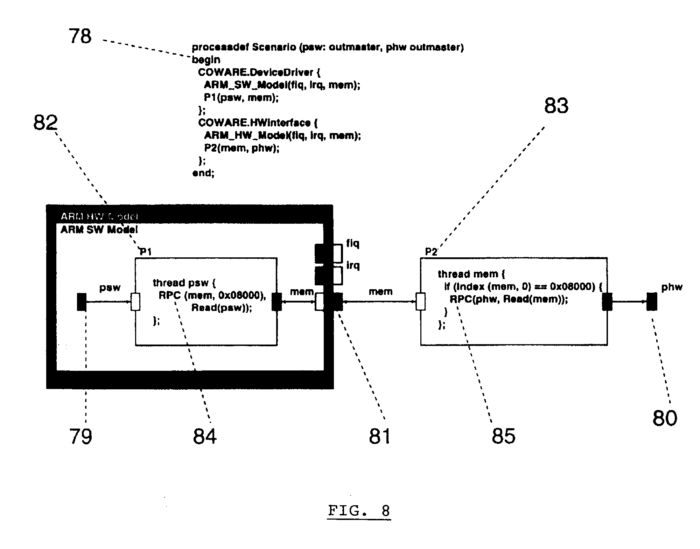

In step (2) when the process is compiled on a programmable processor, the implementation of inter-process communication comprises the steps of generating device drivers and of generating hardware interfaces. A software tool is used to achieve this. In the sequel this tool is called SYMPHONY. FIGURE 7 illustrates the tool SYMPHONY.

SYMPHONY makes use of a software model (71) and hardware model (72) of the target processor and a library of I/O scenarios (73) for that processor. The hardware model (72) of the programmable processor core consists of a HDL host-language encapsulation that formalizes the information that is available in the hardware section of the data sheet of the programmable processor core. The HDL host-language encapsulation of the hardware model is characterized by a behavioral interface that is conform with the hardware interface of the programmable processor. All ports (74) have hierarchical protocols: they consist of terminals and a timing diagram. The hardware model may also contain a HDL description for either a black box, a simulation model, or the full description of the processor core.

The software model (71) of the programmable processor core consists of a software host-language encapsulation that formalizes the information that is available in the software section of the data sheet of the programmable processor. The software host-language encapsulation of the software model is characterized by a behavioral interface that is conform with the software interface of the programmable processor core. All ports (75) have primitive protocols. The software model identifies, for example, what ports can be used to get data in or out of the processor core (memory mapped, co-processor port,...), what ports can be used as interrupt ports and what their characteristics are (interrupt priority, maskable interrupt,...). In addition the software model contains a behavioral description that allows to compile a software host language encapsulation into machine code. For example: functions to manage processor specific actions such as installing an interrupt vector, enabling/disabling interrupts, etc. In Figure 7, the software model of the ARM-6 RISC processor is shown. A number of its ports (75) are shown in Figure 7. The memory port mem is modeled as a (bi-directional) slave port. This slave port is accessed by the device drivers, by means of an RPC, to write/read data to/from the external hardware. The slave thread, modeled in the software model, attached to the mem slave port translates the incoming RPC to a memory access. SYMPHONY makes the connection between the device drivers and the mem port. The fiq port is modeled as a master port. The software model of the ARM processor ensures that an RPC to this port is performed, every time the processor detects that an interrupt has occurred. SYMPHONY connects the fiq port to a slave thread that serves as the interrupt service routine, so that routine is started automatically.

In figure 7, the hardware model of the ARM-6 RISC processor is shown. A number of its ports (74) are shown in Figure 7. The memory port mem is modeled as a (bi-directional) master port. The hardware model of the ARM-performs an RPC to port every time that it wants to write/read data from the RAM, ROM or memory mapped hardware. SYMPHONY connects the mem port to a slave thread in the hardware interface, which does the address decoding and forwards the RPC to the appropriate hardware block (RAM, ROM, memory mapped hardware).

The fiq port is modeled as a slave port in the hardware model. This slave port is activated by an RPC that is performed to the port by the hardware interface. The slave thread attached to the fiq port (and modelled in the hardware model) sets the appropriate flag in the status register to the appropriate value, signalling the interrupt request.

The link between events (RPC to ports, starting of slave threads attached to slave ports) in the hardware model and events in the software model, is taking care of by the processor hardware or, in case of simulation, by the instruction-set simulator for the ARM.

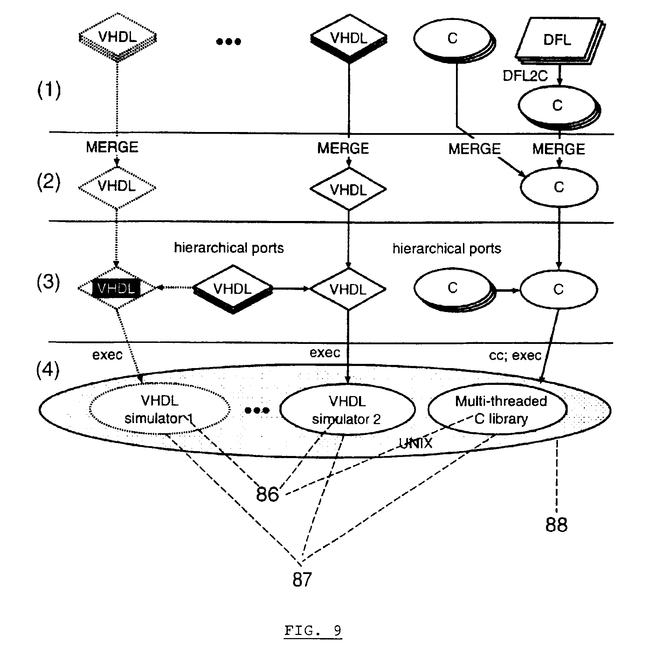

SYMPHONY is based on the observation that programmable processors have a number of common communication methods to get data in or out of the processors. These communication methods are modeled by I/O scenarios. An I/O scenario describes one way of using the ports of a specific processor core to map a particular port of a software host language encapsulation to an equivalent port in hardware, thereby crossing the processor core boundary while maintaining the communication semantics. FIGURE 8 shows an example of an I/O scenario. It consists of a software host-language encapsulation and a hardware host-language encapsulation that describe a software I/O driver and the hardware counterpart, respectively. An I/O scenario is also tagged with some performance figures that will allow the designer or SYMPHONY to make a decision about what I/O scenario to use for which port.

The I/O scenario (78) of FIGURE 8 shows how an outmaster port psw (79) in software can be mapped to an outmaster port phw (80) in hardware, thereby using the memory port (81) of an ARM-6 RISC processor core. The software process encapsulation P1 (82) represents the software I/O driver and copies data from port psw (79) to a specific memory address 0x08000 via an RPC call (84). The hardware process encapsulation P2 (83) represents the hardware counterpart and checks whether the memory address bus of the ARM (modeled by the protocol indices of the memory port (81)) equals 0x08000. If this is the case, data that is residing on the memory data bus of the ARM is copied to port phw (80) via an RPC call (85).

The library of I/O scenarios comprises:
- Memory-Mapped I/O scenarios. These provide a data-transfer mechanism that is convenient because it does not require the use of special processor instructions, and can implement practically as many input or output ports as desired. In memory-mapped I/O, portions of the address space are assigned to input and output ports. Reads and writes to those addresses are interpreted as commands to the I/O ports. "Sending" to a memory-mapped location involves effectively executing a "Store" instruction on a pseudo-memory location connected to an output port, and "Receiving" from a memory-mapped location involves effectively executing a "Load" instruction on a pseudo-memory location connected to an input port. When these memory operations are executed on the portions of address space assigned to memory-mapped I/O, the memory system ignores the operation. The I/O unit, however, sees the operation and performs the corresponding operation to the connected I/O ports. The number of memory locations assigned for memory-mapped I/O will depend on the number of ports that a software processor component has to "physically" implement. SYMPHONY proposes an assignment of address locations to channels that will result in simple address decoding logic. However, the user can always override the proposed assignment.
- Instruction-Programmed I/O scenarios. Some processors also provide special instructions for accessing special I/O ports provided with the processor itself. Using this scheme, these special communication ports of the processor are connected to the external channels via the I/O unit. In addition to providing hardware support for memory-mapped and instruction-programmed I/O, the I/O unit also provides support for hardware interrupt control. Interrupts are used for different purposes, including the coordination of interrupt-driven I/O transfers. Different processors provide different degree of hardware interrupt support. Someprocessors provide direct access to a number of dedicated interrupt signals. Our I/O unit architecture makes use of these signals when available. If more interrupt "channels" are required, as for example required to support a number of interrupt-driven communication channels, we use the strategy of interrupt vectors. Interrupt vectors are pointersor addresses that tell the processor core where to jump to for the interrupt service routine. In effect, this is a kind of memory-mapped interrupt handling.
   Once an I/O scenario is selected for every port of the software host-language encapsulation, SYMPHONY generates the necessary communication software and the corresponding hardware I/O unit by combining the selected I/O scenarios. The generated communication software, the software model of the processor core and the software host-language encapsulation itself are merged and compiled with the processor specific C-compiler.
   The result of SYMPHONY is a refinement of the original host language encapsulation into a CoWare encapsulation of which the behavioral interface is identical to that of the original encapsulation.

In addition SYMPHONY, adds RAM and ROM blocks to store the program code and data (In figure 7, the RAM and ROM are not shown explicitly : they are part of the HW interface). The result of SYMPHONY is a refinement of the original host language encapsulation into a CoWare encapsulation of which the behavioral interface is identical to that of the original encapsulation. SYMPHONY effectively replaces a software encapsulation by a hardware encapsulation that has equivalent functionality.

In step (3) when two processors are not protocol compatible, a protocol conversion process is inserted. In FIGURE 6, the processor (65) compiled with Cathedral-2/3 and the off-the-shelf processor (76) have incompatible protocols. Protocol conversion (77) is required to make them compatible.

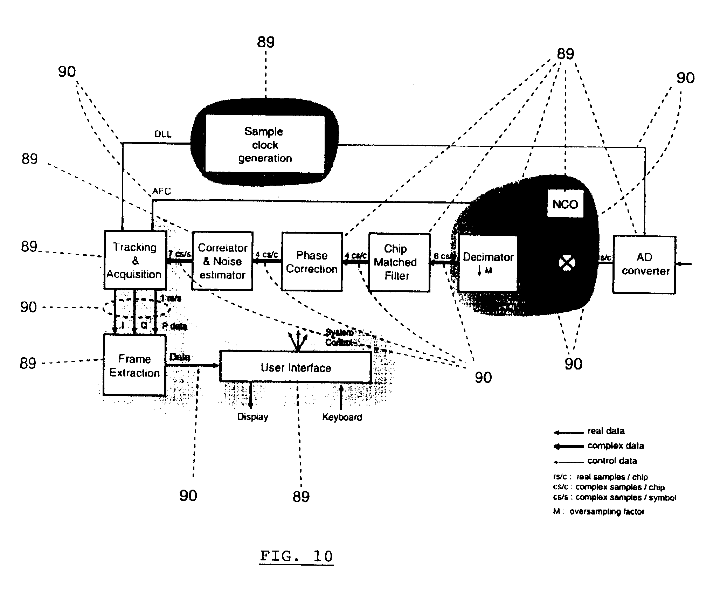

A digital system in the CoWare design environment can be simulated. Simulation is an implementation of the digital system on one or more general-purpose computers. The implementation process outlined above can be followed to construct a simulation. FIGURE 9 illustrates the construction of a simulation. For simulation the target processors are simulators (86) running on processes (87) of the operating systems (88) that run on the general-purpose computers. Allocation and assignment determine the simulation architecture. Arbitrary simulation architectures are supported by the CoWare design environment. Support is provided to select an optimal architecture for a given simulation speed and debugging visibility.

The host language compilers mentioned in step (1) are now the simulation engines for the host languages.

In step (2), the inter-process communication now consists of two parts. In a first part the communication is realized from the simulation engine to the OS process on which the simulation engine is running. In a second part the communication is realized between two different OS processes over the OS and network layer. The communication between the simulation engine and the OS process is performed via the application programmers interface of the simulation engine. The communication between two different OS processes is done through the OS inter-process communication primitives (e.g. shared memory and semaphores for two processes on a single OS, or TCP/IP sockets for two processes on distinct computers).

When the simulation engine used has a fixed interface as for example an instruction set simulator for a programmable processor, then the hardware software interface is generated with SYMPHONY and can be simulated as any other process.

The CoWare design environment supports multi abstraction level simulation which is the key for efficient co-simulation. It allows to simulate the processes under debug at an appropriate low level of abstraction for debugging purposes, while simulating the other processes in the system at the highest appropriate abstraction level for maximal speed. The time-consuming low abstraction level simulation is limited to the smallest possible part of the system under simulation, while still being able to simulate these parts in the system context.

Because both simulation and implementation follow the same design process, it is possible to construct hybrid simulation architectures in which part of the system is implemented by simulators running on OS processes and part of the system is implemented by actual hardware. This is just one more manifestation of the heterogeneity of digital system architectures.

In a specific embodiment of the present invention an application is disclosed in the sequel for hardware/software co-design of a pager application.

### SPECIFICATION OF THE PAGER

Each block (89) in FIGURE 10 corresponds to a process implementing a specific function of the pager. This functional decomposition determines the initial partitioning. The arrows (90)in between the processes represent primitive channels with RPC semantics.

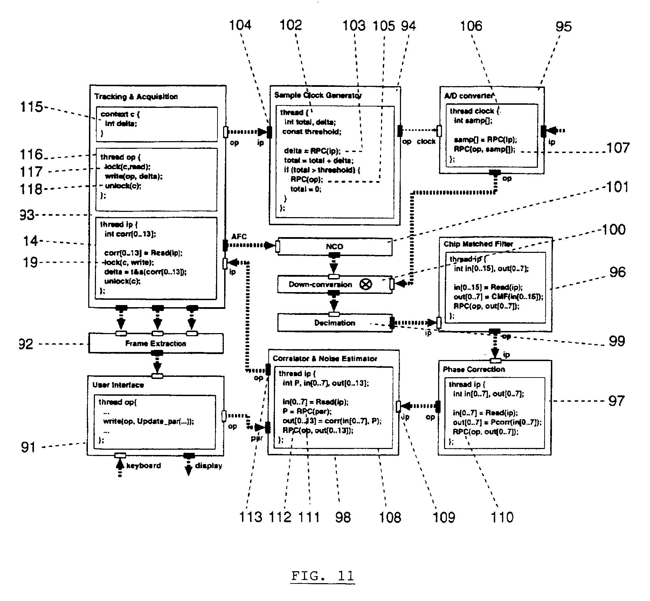

FIGURE 11 shows the RPC communication in detail for part of the pager design. The blocks (91, 92, 93, 94, 95, 96, 97, 98, 99, 100, 101) in FIGURE 11 correspond to the processes (89) from FIGURE 10.

The Sample Clock Generator process (94) contains an autonomous thread (102). This thread runs continuously. It performs an RPC (103) over its input port ip (104) to the Tracking & Acquisition process (93) to obtain a new value for delta. The autonomous thread (102) of the process (94) adds the delta parameter to some internal variable until a threshold is exceeded. In this way it implements a sawtooth function. When the sawtooth exceeds the (fixed) threshold an RPC call (105)is issued to the A/D converter process (95). The autonomous thread (102) of the Sample Clock Generator (94) performs an RPC (105) (gives a sample clock tick) every threshold/delta iterations (real clock cycles).

The slave thread clock (106) in the A/D converter process (95) samples the analogue input, and sends the result to the Down-conversion process (100) via an RPC call (107). This in turn will activate the Decimation process (99) via an RPC call, etc.

The Correlator Noise Estimator process (98) contains a slave thread (108) associated with port ip (109) to compute the correlation values. This slave thread (108) is activated when the Phase Correction process (97) writes data to the Correlator Noise Estimator process (98) (i.e. when the Phase Correction process (97) performs an RPC (110) to the ip (109) port of the Correlator Noise Estimator process (98)). The slave thread (108) reads in the data and then performs an RPC (111) to the User Interface process (91) to obtain a new value for the parameter par it requires for computing the correlation values. Finally, the new correlation results are sent to the Tracking Acquisition process (93) via an RPC call (112) on its op port (113).

The slave thread (114) in the Tracking Acquisition process (93) updates the delta value for the sawtooth function implemented by the Sample Clock Generator process (94). It puts the updated value in the context (115), where it is retrieved by the slave thread op (116) which serves RPC requests from the Sample Clock Generator process (94). In this way the Tracking Acquisition process (93) influences the frequency of the clock generated by the Sample Clock Generator process (94). This example shows how the context (115) is used for communication between threads inside the same process whereas the RPC mechanism is used for communication between threads in different processes. The locking (117) and unlocking (118) of the context (115) is required to avoid concurrent accesses to the variable delta. The lock (117) in the slave thread op (116)locks the context (115) for read: other threads are still allowed to read from the context (115), but no other thread may write the context (115). The lock (119) in the slave thread ip (114) locks the context (115) for write: no other thread is allowed to write or read the context (115) until it is unlocked again.

Each process is described in the language that is best fit for the characteristics of the function it implements The data-flow blocks (NCO (101), Down-conversion (100), Decimation (99), Chip Matched Filter (96), Phase Correction (97), Correlator Noise Estimator (98), and Sample Clock Generator (94)) are described in DFL. The control oriented blocks (Tracking Acquisition (93), Frame Extraction (92) and User Interface (91)) are described in C. The code in FIGURE 11, is pseudo-code meant for illustration and does not correspond to the actual code.

### DESIGN PROCESS

After the initial specification of the system has been validated by simulation, the designer starts the refinement process.

At this moment it is not yet decided what process will be implemented on what kind of target processor nor is it defined how the RPC communication will be refined. However, the choice of the specification language for each process restricts the choice of the component compiler and in that sense partly determines the target processor. Hence, studying possible alternative assignments of a process to a target processor may require the availability of a description of the process in more than one specification language or a clear guess of the best solution.

### ALLOCATION AND ASSIGNMENT

This step determines what processes will be implemented on what target processor. The initial specification shows the finest grain partitioning: a process in the initial specification will never be split over several processors. However, it may be worthwhile to combine a number of processes inside a single processor. This is achieved by merging these processes into a single process that can then be mapped on the selected target processor by a host language compiler. Merging of processes is only allowed when the processes are described in the same specification language. Hence, studying possible alternative mergers may require that for a number of processes (e.g. Correlator Noise Estimator process) a description is available in more than one specification language. After allocation and assignment, one obtains a description with a one-to-one mapping of merged processes to processors.

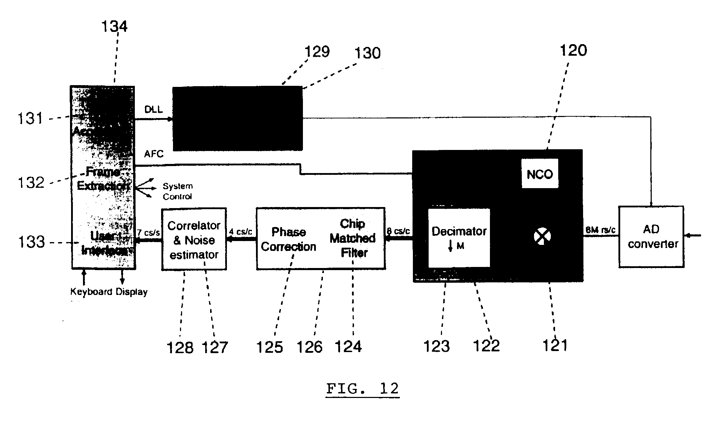

In the pager example (FIGURE 12) the following allocation, merging and assignment takes place.

The NCO (120), Down-conversion (121), and Decimation (122) processes are merged and mapped in hardware onto an application specific DSP processor (123) because the sample rate of the merged processes is identical which implies that they can be clocked at the same frequency. The advantage is that only one clock tree needs to be generated per merged process (i.s.o. one per original process). An additional advantage is that the scan-chains for the processes that are merged can be combined.

The Chip Matched Filter (124), and Phase Correction (125) processes are merged and mapped onto a CATHEDRAL-3 processor (126) because their sample rates are identical.

The Correlator Noise Estimator process (127) is mapped onto a CATHEDRAL-3 processor (128). It is not merged with the Phase Correction process (125) because it operates at a four times lower frequency.

The Sample clock generator (129) is mapped onto a CATHEDRAL-3 processor (130).

Tracking Acquisition (131), Frame Extraction (132), and User Interface (133) are merged and mapped on a programmable processor (134). For this design an ARMS processor is chosen.

The Hardware/Software tradeoffs are based on the following observations. To obtain a maximal degree of flexibility as much of the functionality as possible is implemented in software on the ARM6 (134). However, due to performance constraints of the ARM6 processor (134), there is a limit to what can be implemented in software. The two main factors that play a role in this problem are The Tracking Acquisition process (131) has to be implemented in software because the algorithm used to perform tracking and acquisition may be modified depending on the application domain of the pager system.

The Correlator Noise Estimator process (127) is not included in software because the input rate for the Correlator Noise Estimator (127) is too high to realize a real-time communication between the ARM6 and the Phase Correction process (125). In addition an estimation of the number of cycles required to execute each function on the ARM6 shows that the implementation of Correlator Noise Estimator process (127) in software leaves insufficient time to perform tracking and acquisition in between every two symbols.

After merging, each of the merged processes can now be implemented on a separate target processor by the appropriate compiler. The communication between the merged processes is still done via primitive ports and channels.

### Communication Mechanism Selection

After the partitioning of the system has been verified by simulation and before the actual implementation takes place, the designer may choose to refine the communication mechanism between the processors. This can be achieved by making explicit the behavior of the channels between the processors.

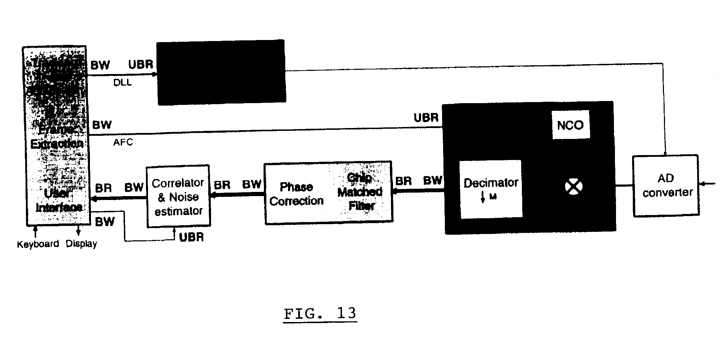

In the running example, the processors can, in principle, operate concurrently because each processor has its own thread of control. By refining the RPC based communication scheme we can pipeline the processors: all processors operate concurrently and at I/O points they synchronize. This refined communication scheme is called Blocked/UnBlocked Read/Write communication. FIGURE 13 shows the pager with the refined communication mechanism. The inputs and outputs of the processors have been labeled with BW for Blocked Write, BR for Blocked Read, and UBR for UnBlocked Read.

BW-BR communication guarantees that no data is ever lost. When the writing process has data available, it will signal that to the reading process. If the reading process is at that moment not ready to receive the data (because it is still processing the previous data), the writing process will block until the reading process is ready to communicate. Alternatively, if the reading process needs new data, it will signal that to the writing process. If the writing process is at that moment not ready to send the data (because it is still computing the data), the reading process will block until the writing process is ready to communicate. The BW-BR scheme is used in the main signal path.

A BW-BR scheme, however, is not used for the parameter and mode setting for the main signal path. If an accelerator uses BR to read a parameter value it will be blocked until the parameter is provided. Since the parameter setting is done in software, this will slow down the computations in the main signal path considerably. Therefore parameter setting is done via a BW-UBR scheme. This makes sure that every parameter change is read by the accelerators, but it leaves it up to the accelerator to decide when to read the parameter.

In the CoWare design environment the refinement of the communication mechanism is performed by making use of a hierarchical channel. A hierarchical channel replaces a primitive channel by a process that describes how communication over that channel is carried out.

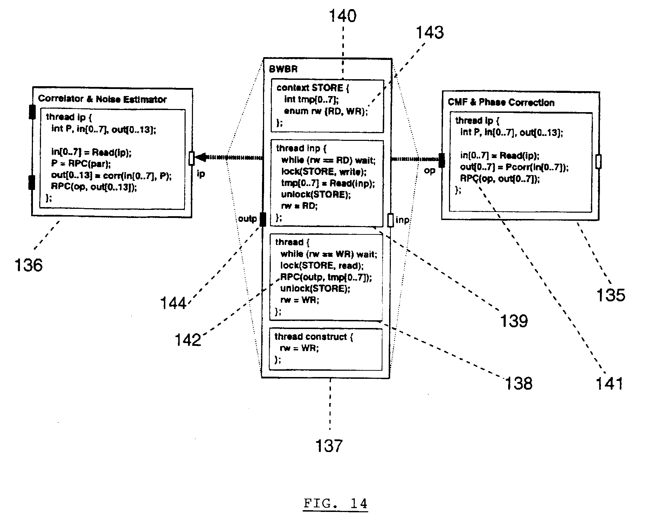

The introduction of BW-BR communication is shown in detail for the Chip Matched Filter & Phase Correction (135) and Correlator & Noise Estimator process (136) in FIGURE 14.

The BWBR channel (137) contains a autonomous thread (138) and a slave thread (139) that communicate with each other via the shared variable tmp[0..7] in the context (140). The slave thread (139) is activated by an RPC (141) from the CMF & Phase Correction process (135) and it tries to update the context (140) with new values. The autonomous thread (138) continuously tries to read the values from the context (140) and send them to the output port (144) via an RPC (142), in this way activating the Correlation & Noise Estimator process (136) that is attached to that output (144). The blocking character of the communication is taken care of by the use of a binary semaphore rw (143). This guarantees that the input thread (139) will block until the previous data has been read by the autonomous thread (138) (no data is overwritten before it has been read), and that the autonomous thread (138) will block until new data is available (no data is read twice). When the input slave thread (139) is blocked, the CMF & Phase Correction process (135) that requested its service via an RPC (141) is also blocked because the RPC (141) will only return after the slave thread (139) has completed. When the autonomous thread (138) is blocked, there are no RPC requests to the Correlator Noise Estimator process (136), so that process (136) is blocked automatically.

In the case of Blocked-Write, UnBlocked Read communication, the code for the autonomous thread is slightly modified. The thread always sends the value stored in the context, without checking whether it is updated. The same value can be sent more than once, but the thread will never be blocked. The input slave thread is identical to the BWBR case, and will block until the data has been read.

In both cases, locking and unlocking of the context is required to avoid concurrent accesses to the shared variable in the context and, as such, has nothing to do with the blocking character of the communication.

### Implementation of the pager

After the newly introduced communication mechanism has been verified by simulation, each process has to be synthesized on its assigned target processor.

### Implementation of a Process in Hardware

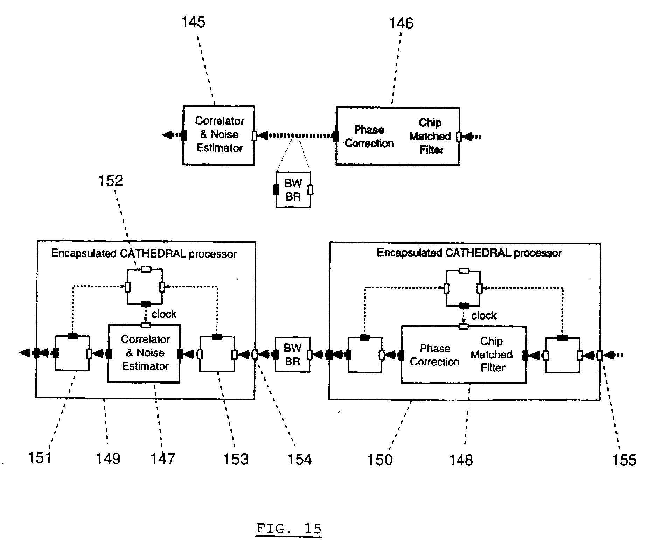

FIGURE 15 illustrates the pure hardware implementation for the Correlator & Noise Estimator process (145) and the merged Phase Correction and Chip Matched Filter process (146).

This hardware implementation for the pager consists of three distinct steps:

The (merged) DFL processes are synthesized by the CATHEDRAL silicon compiler. The compiler generates processors of which all the inputs and outputs are of the master type. These processors are shown in FIGURE 15 as the inner rectangles (147, 148).

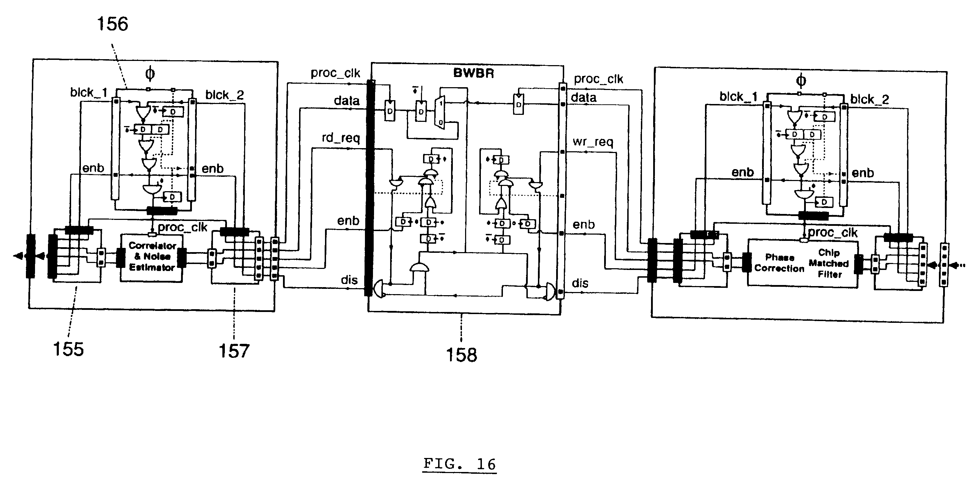

Each processor is encapsulated to make it consistent with the specification in which the DFL processes have slave inputs. In addition, the encapsulation includes clock gating circuitry to control the activity of the processor. The encapsulated processors are shown in FIGURE 15 as the big rectangles (149, 150): they include the processor generated by CATHEDRAL (147, 148) and some encapsulation hardware (151, 152, 153). As can be observed the input ports (154, 155) of the encapsulated processors (149, 150) are now of the slave type. The encapsulation hardware (151, 152, 153) is shown in detail in FIGURE 16 as the blocks (155, 156, 157).

The BWBR process is implemented in hardware. In this case we obtain the gate-level implementation of this process from the library. This implementation is functionally equivalent to the original C-like description (137) of this block in FIGURE 14. FIGURE 16 shows the detailed implementation (158) of the BWBR process that is used in the main signal path of the pager.

### Implementation of a Process in Software

To simplify the discussion we will only look at the transfer of the 14 correlation values to the Tracking Acquisition process, and the setting of a parameter value by the User Interface. We also know that the transfer of the correlation values has to be BWBR and the transfer of the parameter value has to be BWUBR.

The hardware interface and the software I/O device driver is generated automatically with SYMPHONY. To generate these interfaces SYMPHONY analyses the ports of the software process. For each of these ports, SYMPHONY scans the library of I/O scenarios for an applicable scenario. The user is asked to select the most appropriate scenario amongst the applicable ones. SYMPHONY then combines the selected scenarios into a software I/O device driver and a hardware interface.

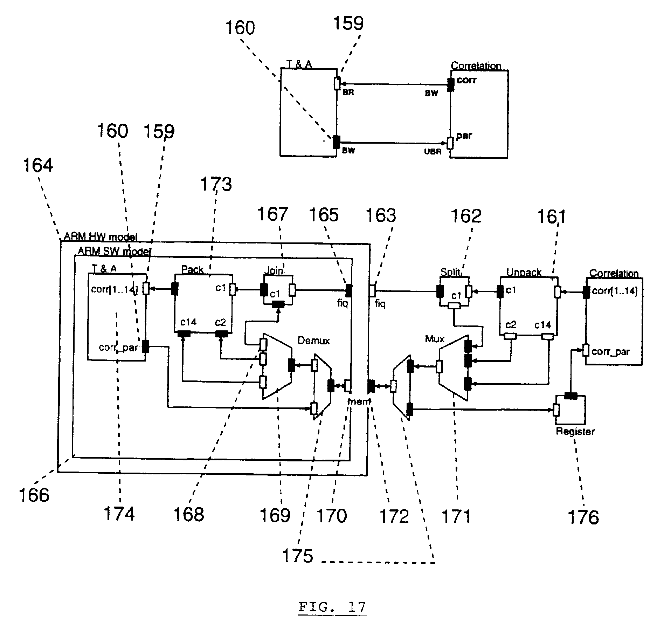

In the example (FIGURE 17) there are two ports to be implemented:
- bool[32][14] corr: inslave (159) is used to transfer the correlation values. This is a port of type inslave, that transports an array of 14 bit vectors of size 32.
- bool par: outmaster (160) is used to set a parameter of the correlation block. This is a port of type outmaster, that transports a boolean value.

For the corr port (159) SYMPHONY proposes the scenario depicted in FIGURE 17. The memory port of the ARM will be used to transfer the correlation values and the FIQ port of the processor will be used to initiate the transfer. The I/O scenario describes what blocks need to be inserted in software and hardware to realize this kind of communication. In total three hardware and three software blocks are required to implement the communication over the corr port. Unpack (161). The memory port of the ARM is obviously not wide enough to transfer the 14 correlation values in parallel. Therefore, the scenario will sequentialize the transfer. Of the 14 correlation values 13 will be stored internally in the Unpack block (161). The 14th value is sent to the Split block (162).

Split (162) stores the 14th value internally and then activates the FIQ port of the ARM processor. Activating the FIQ port (163) of the hardware model (164), has as a consequence that an RPC is issued on the interrupt port (165) of the software model (166). This port (165) is connected with the Join (167) block.

Join (167) retrieves the 14th correlation value by issuing an RPC to the corresponding input port (168) of the Demux block (169). Demux (169). The data transfer is implemented through memory mapped I/O. Therefore, when selecting this I/O scenario, the user should decide on the address that will be used for the transfer. When one of the input ports of the Demux block is activated an RPC to the memory port (170) will be performed with an address that corresponds to the activated input port.

Mux (171). At the hardware side the memory port (172) issues an RPC to the Mux (171) block whenever it (172) is activated. In that block (171), the address will be decoded and the corresponding output port will be activated to retrieve the correlation value that was stored locally in hardware (either in the Split (162) or in the Unpack block (161)) Pack (173). After the 14th correlation value has been retrieved by the Join block (167), it is passed on to the Pack block (173), that will then retrieve the 13 other correlation values by issuing consecutive RPCs to the different ports of the Mux block (169). Finally, when the Pack block (173) has retrieved all 14 values, it packs them in an array and activates the original software application code in the Tracking & Acquisition process (174).

All these blocks are described in a generic way in a library where they can be retrieved and customized by SYMPHONY.

The solution for the par port (160) is much simpler. Since it is an outmaster port it can directly be mapped on the memory port. However, since the memory port is already used, an extra multiplexer (175) is required. This is shown in FIGURE 17. To implement the unblocking read character of the transfer an extra register (176) is required on the hardware side.

Before going on with the implementation path, all processes that were added by SYMPHONY are merged. The hardware interfaces are merged into one hardware interface block that can then be implemented with RT-level synthesis tools. The I/O device driver processes are merged with the original SW application code. As a consequence of the in-lining, the complete tracking and acquisition slave thread moves in the interrupt routine. Whenever new correlation values are ready, the main software thread is interrupted to run the tracking and acquisition algorithm. After that interrupt is processed, the main thread resumes.

In the above description a design environment and a design methodology meeting the requirements of modularity, encapsulation of different description languages, modeling from a heterogeneous conceptual specification to a resulting heterogeneous architecture and all refinement steps inbetween, modeling capabilities for off-the-shelf components and the associated design environments, separation between functional and communication behavior and processor independent interface synthesis have been disclosed. Yet it is apparent that other embodiments of the present invention may be obvious to the person skilled in the art, the spirit and scope of the present invention being limited only by the terms of the appended claims.

## Claims

1. A design apparatus compiled on a computer environment for generating from a heterogeneous specification a heterogeneous implementation of a system, said system comprising at least one digital system part, said heterogeneous specification comprising a number of paradigms having associated behavioural and structural languages, said heterogeneous implementation comprising hardware parts and software parts, said apparatus comprising:
- a database compiled on said computer environment, adapted for access by executable programs on said computer environment for generating the implementation of said system, said database comprising a plurality of objects representing aspects of said system wherein said objects comprise primitive objects representing the specification of said system and hierarchical objects being created by said executable programs while generating the implementation of said system, said hierarchical objects being refinements of said primitive objects and having more detail and preserving any one or all of said aspects to thereby generate said implementation of said system; and said database further comprising relations in-between said primitive objects and in-between said hierarchical objects and between said primitive objects and said hierarchical objects; and further comprising functions for manipulating said objects and said relations;
- means for simulating said system comprising a plurality of simulators for said behavioural and structural languages;
- means for implementing said system comprising a plurality of compilers for said behavioural and structural languages; means for allocating hardware components for an implementation of said system;
- means for assigning hardware subsystems and software subsystems to allocated hardware components;
- means for implementing the communication between said software subsystems and said hardware subsystems, one of the aspects of said communication being represented by ports; characterized in that said apparatus further comprises:
- means for creating processor models of said allocated hardware components as primitive objects in said database, said models comprising software models representing the software views on said hardware components and hardware models representing the hardware views on said hardware components,
- means for specifying said system in said apparatus, the specification in said apparatus comprising processes being primitive objects and comprising ports, said ports structuring the communication between said processes and being primitive objects, said process comprising a description of each of the different parts of said system in a specific host language encapsulation, said encapsulation comprising threads and context, a plurality of behavioural and structural languages being supported in said apparatus, and
- means for encapsulating said simulators, said compilers, said hardware components, said hardware subsystems and said software subsystems in said apparatus to thereby create a consistent communication between said encapsulation and said encapsulated simulators, compilers, hardware components, hardware subsystems and software subsystems, thereby enabling the refinement process of said primitive objects while generating the implementation of said system.

2. The design apparatus as recited in claim 1 further comprising means for creating I/O scenario models of said ports as objects in said database, said I/O scenario models representing the implementation of said ports on said hardware components, said implementation comprising said software subsystems, said hardware subsystems, and processor models with connections therebetween.

3. The design apparatus as recited in claim 2 wherein the implementation of the communication between a first software subsystem and a first hardware subsystem results in said first software subsystem with a first port being replaced by a second hardware subsystem with a second port, said first port and said second port representing an essentially identical communication.

4. The design apparatus as recited in claim 3 further comprising:
- means for selecting I/O scenario models for the ports of said first software subsystem;
- means for combining the software subsystems of the selected I/O scenarios;
- means for combining the hardware subsystems of the selected I/O scenarios.

5. The design apparatus as recited in claim 4 wherein a first I/O scenario model represents the connection of said first port to said second port, said connection comprising a connection of said first port to said software subsystems of said I/O scenario model, connections of said software subsystems of said I/O scenario model to said software model, connections of said hardware model to said hardware subsystems of said I/O scenario model, and a connection of said hardware subsystems of said I/O scenario model to said second port.

6. The design apparatus as recited in claim 5 wherein I/O scenario models comprise memory mapped I/O scenarios, instruction programmed I/O scenarios, interrupt based I/O scenarios.

7. The design apparatus as recited in claim 1 wherein said implementation is a simulation of said digital system.

8. The design apparatus as recited in claim 7 wherein said simulation is a multi-platform simulation being executed on a plurality of computers.

9. The design apparatus as recited in claim 8 wherein said simulation is a hybrid simulation comprising substantially simultaneous hardware implementations and computer simulations.

10. The design apparatus as recited in claim 1 wherein said software subsystems are executed on one or more of said hardware subsystems.

11. The design apparatus as recited in claim 10 wherein said hardware subsystems comprise any one or more of processor cores, off-the-shelf components, custom components, ASICs, processors, or boards.

12. The design apparatus as recited in claim 1 wherein said aspects are functional or communication or concurrency or structural aspects of said digital system.

13. The design apparatus as recited in claim 1, wherein said refinements are individual refinements.
